# EUROPEAN PATENT SPECIFICATION

(11) **EP 4 007 170 B1**
(45) Date of publication and mention of the grant of the patent: **30.08.2023**
(21) Application number: 21199296.1
(22) Date of filing: 28.09.2021
(51) Int. Cl.: H03K 17/795

(54) **DRIVE DEVICE**
ANTRIEBSVORRICHTUNG
DISPOSITIF DE CONDUITE

(30) Priority: 25.11.2020 JP 2020195509
(43) Date of publication of application: 01.06.2022
(73) Proprietor: Fuji Electric Co., Ltd., Kawasaki-shi, Kanagawa 210-9530 (JP)
(72) Inventor: NARITA, Hikaru, Kawasaki-shi, Kanagawa, 210-9530 (JP)
(74) Representative: Appelt, Christian W.

(56) References cited:
- JP-A- H02 107 019
- US-B1- 6 181 189
- US-B1- 7 528 399

## Description

### BACKGROUND OF THE INVENTION

### 1. Field of the Invention

The present disclosure relates to a drive device.

### 2. Description of the Related Art

For example, a drive device that drives a loading device such as an electric motor by using an external input signal, has been known (see Japanese Laid-Open Patent Application No. 2018-136712).

Japanese Laid-Open Patent Application No. 2018-136712 discloses a servo driver that uses an input signal depending on the operational state of an emergency stop switch, to activate a safety function (safe torque-off function) of an electric motor to be driven.

US 6 181 189 B1 describes an interface circuit composed to provide: changeover switch that switches between a connection state in which pull-up resistor is connected to input terminal and a connection state in which pull-down resistor is so connected; and microcomputer that discriminates whether it is sink input or source input by discriminating the switch connection state of this changeover switch. Moreover, the interface circuit is composed to switch between a signal output state that outputs a signal that is an inversion of the input signal and a signal output state that outputs the input signal as it stands, based on the above discrimination result by this microcomputer.

JP H02 107019 A describes that when a common voltage is set at +24V, a digital signal is supplied to a first connector and the used common voltage is supplied to a second connector. The common voltage drives a relay driving circuit from a receiver and a driver, a relay contact point is connected to a 0V-side, and the input voltage of a receiver is defined. In addition, when the common voltage is at 0V, the input side of the receiver becomes a ground potential through the second connector, the relay driving circuit is not turned on, the relay contact point is connected to a +24V-side, and the input voltage of the receiver is defined.

Meanwhile, for example, in the case where a predetermined function such as a safety function described above is disabled, in some cases, relevant input signals are not used. In this case, input terminals of the device corresponding to the relevant input signals are not connected to signal lines for transmission of the relevant input signals, and stay in an unused state.

However, in the case where the input terminals are unused, it may be necessary to maintain (fix) the electric potential of an input circuit that receives the relevant input signals in a state where the relevant input signals are not being input.

Therefore, for example, when the drive device is shipped, a method is adopted that uses an external wire such as a shorting bar or jumper wire to form a short circuit between a power supply or the like and the unused input terminals, so as to fix the electric potential of the unused input terminal. Therefore, problems such as an increased cost due to the workload for wiring of the external wire, and malfunction of the drive device due to incorrect wiring work may occur.

Thereupon, in view of the above problems, the present invention has an object to provide a technique with which an external wire conventionally connected to input terminals that are assumed to stay in an unused state is omitted for a drive device that drives a loading device such as an electric motor.

### SUMMARY OF THE INVENTION

The object described above is achieved by a drive device according to claim 1. Claims 2 to 7 refer to specifically advantageous realizations of the drive device according to claim 1.

According to one aspect in the present disclosure,
a drive device (1) is provided that includes
an input terminal (EN1, EN2) connectable to a predetermined signal line;
an input circuit (240, 241) connected to the input terminal (EN1, EN2) of the drive device (1)to receive a signal input through the input terminal (EN1, EN2);
a constant electric potential part (CVS) configured to provide an electric potential that is maintained within the predetermined range;
a signal-using part (230) configured to receive an input signal; and
a switching part (250) configured to perform switching between a first state and a second state,
wherein in the first state the constant electric potential part (CVS) is enabled to provide the electric potential as the input signal to the signal-using part (230), and in the second state the input circuit (240, 241) is enabled to provide the signal input through the input terminal (EN1, EN2) as the input signal to the signal-using part (230).

According to the aspect described above, an external wire conventionally connected to input terminals that are assumed to stay in an unused state can be omitted for a drive device that drives a loading device such as an electric motor.

### BRIEF DESCRIPTION OF THE DRAWINGS

FIG. 1 is a diagram illustrating an example of a configuration of an inverter device;
FIG. 2 is a diagram illustrating an example of another configuration of the inverter device; and
FIG. 3 is a diagram illustrating a configuration of an inverter device according to a comparative example.

### DESCRIPTION OF THE PREFERRED EMBODIMENTS

In the following, embodiments will be described with reference to the drawings.

### [Configuration of inverter device]

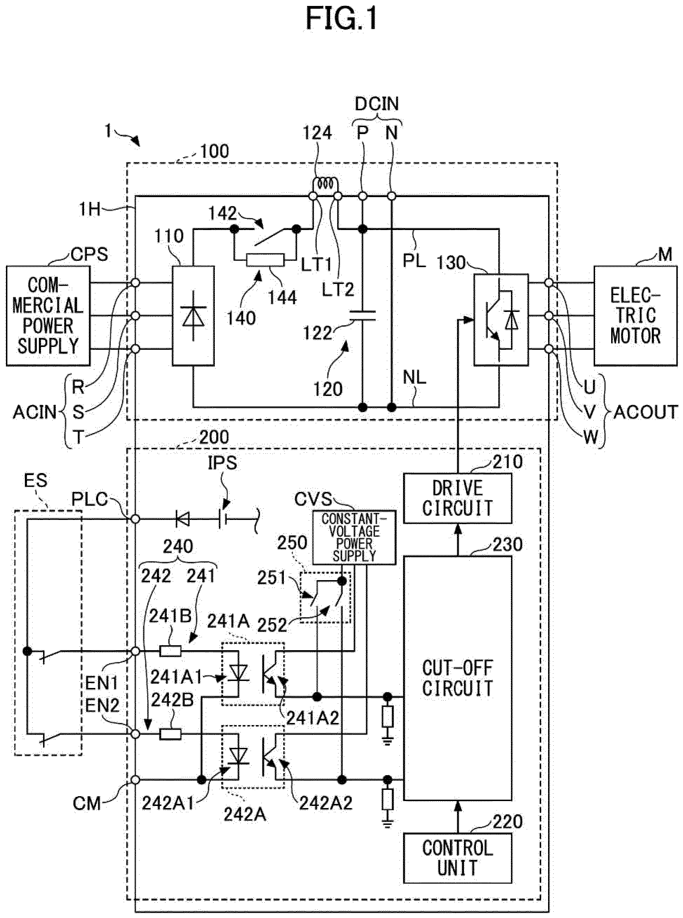

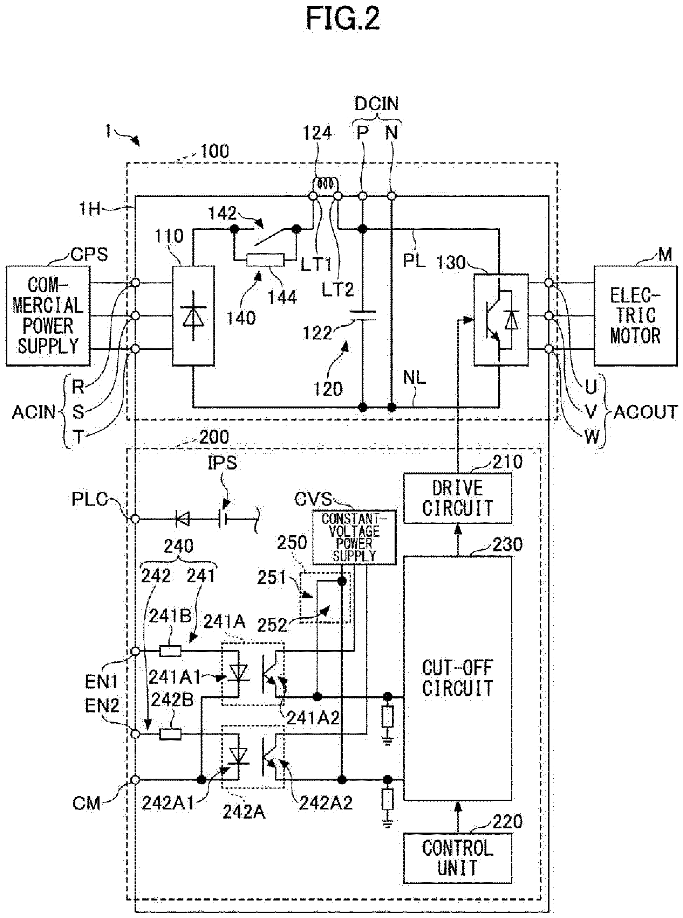

First, with reference to FIGs. 1 and 2, configurations of an inverter device 1 according to the present embodiment will be described.

FIGs. 1 and 2 are diagrams illustrating examples of configurations of the inverter device 1 according to the present embodiment. Specifically, FIG. 1 is a diagram illustrating a state of the inverter device 1 in an operation mode in which a safety function related to an electric motor M operates; and FIG. 2 is a diagram illustrating a state of the inverter device 1 in a non-operation mode in which the safety function related to the electric motor M does not operate.

The inverter device 1 (an example of a drive device) generates AC power having a predetermined voltage and a predetermined frequency to drive a loading device, based on power input through at least one of an AC input part ACIN and a DC input part DCIN.

For example, as illustrated in FIGs. 1 and 2, the inverter device 1 rectifies AC power of a commercial power supply CPS input through the AC input part ACIN, converts the AC power to DC power, and converts the DC power to predetermined AC power to drive the electric motor M (an example of a loading device). Also, for example, the inverter device 1 may convert DC power input from DC common bus lines or the like through the DC input part DCIN to the predetermined AC power, to drive the electric motor M. Also, for example, the inverter device 1 may convert both of the DC power input through the DC input part DCIN, and the DC power converted from the AC power input through the AC input part ACIN, to the predetermined AC power, to drive the electric motor M. Also, for example, the inverter device 1 may drive another loading device different from the electric motor M, based on power input through at least one of the AC input part ACIN and the DC input part DCIN.

As illustrated in FIGs. 1 and 2, the inverter device 1 includes a main circuit unit 100 and a control circuit unit 200. Various components of the inverter device 1 including the main circuit unit 100 and the control circuit unit 200 are housed inside the housing 1H, or attached to a surface of the housing 1H to be exposed outside of the housing 1H.

The main circuit unit 100 includes the AC input part ACIN, a rectifier circuit 110, a smoothing circuit 120, an inverter circuit 130, an AC output part ACOUT, a charging circuit 140, and the DC input part DCIN.

The AC input part ACIN is used for inputting three-phase AC power of R, S, and T phases from the outside. In the present example, the AC input part ACIN can receive the three-phase AC power of the R, S, and T phases through three power lines extending from the commercial power supply CPS. The AC input part ACIN includes an AC input terminal R, an AC input terminal S, and an AC input terminal T connected to power lines of the R, S, and T phases, respectively.

The rectifier circuit 110 is configured to rectify the three-phase AC power of the R, S, and T phases input from the AC input part ACIN, and to be capable of outputting DC power. The rectifier circuit 110 has a positive output terminal and a negative output terminal that are connected to one end of a positive line PL and one end of a negative line NL, respectively, and through the positive line PL and the negative line NL, can output the DC power to the smoothing circuit 120. The rectifier circuit 110 is, for example, a bridge-type full-wave rectifier circuit that includes six diodes, and has three sets of series connections of two diodes constituting upper and lower arms connected in parallel.

The smoothing circuit 120 suppresses pulsation of DC power output from the rectifier circuit 110, DC power input through the DC input part DCIN, and DC power output (regenerated) from the inverter circuit 130, to smooth the power.

The smoothing circuit 120 includes a smoothing capacitor 122 and a reactor 124.

The smoothing capacitor 122 is provided in parallel with the rectifier circuit 110 and the inverter circuit 130, on a path that connects the positive line PL and the negative line NL.

The smoothing capacitor 122 smooths DC power output from the rectifier circuit 110, DC power input through the DC input part DCIN, and DC power output (regenerated) from the inverter circuit 130, while repeating charging and discharging appropriately.

Only one unit of the smoothing capacitor 122 may be provided. Alternatively, multiple smoothing capacitors 122 may be provided, and the multiple smoothing capacitors 122 may be connected in parallel between the positive line PL and the negative line NL, or may be connected in series. Also, the multiple smoothing capacitors 122 may be configured such that series connections of two or more smoothing capacitors 122 are connected in parallel between the positive line PL and the negative line NL.

The reactor 124 is provided along the positive line PL between the rectifier circuit 110 and the smoothing capacitor 122 (specifically, at a branch point of the path on which the smoothing capacitor is arranged). For example, as illustrated in FIGs. 1 and 2, the reactor 124 may be arranged to make a connection between reactor connection terminals LT1 and LT2 that are pulled out of both ends of a section of the positive line PL between the rectifier circuit 110 and the smoothing capacitor 122. Also, for example, the reactor 124 may be embedded inside the housing 1H of the inverter device 1.

The reactor 124 smooths DC power output from the rectifier circuit 110, DC power input from the DC input part DCIN, and DC power output (regenerated) from the inverter circuit 130, while generating a voltage to prevent change in current appropriately.

Note that the reactor 124 may be omitted. In this case, in FIGs. 1 and 2, a conductor for short circuiting is connected between the reactor connection terminals LT1 and LT2.

The inverter circuit 130 has a positive input terminal and a negative input terminal connected to the other end of the positive line PL and the other end of the negative line NL, respectively. The inverter circuit 130 converts, by switching operations of a semiconductor switching element, DC power supplied from the smoothing circuit 120 through the positive line PL and the negative line NL, into three-phase AC power of U, V, W phases having a predetermined frequency and a predetermined voltage, and outputs the converted power to the electric motor M. The semiconductor switching element may be, for example, an insulated gate bipolar transistor (IGBT) made of silicon (Si) or a metal-oxide-semiconductor field-effect transistor (MOSFET). Also, the semiconductor switching device may be, for example, a semiconductor device using a semiconductor having a wide band gap such as silicon carbide (SiC) or gallium nitride (GaN).

The inverter circuit 130 is configured to include, for example, six semiconductor switching elements, and a bridge circuit in which three sets of series connections (switch legs) are connected in parallel between the positive line PL and the negative line NL, where each of the switch legs is constituted with two of the six semiconductor switching elements to configure upper and lower arms. Further, the inverter circuit 130 may output three-phase AC power through a U-phase line, a V-phase line, and a W-phase line pulled out of connection points of the three sets of the upper and lower arms. Also, each of the six semiconductor switching elements may have a circulating diode connected in parallel.

The AC output part ACOUT is connected to the electric motor M through the three power lines of the U, V, and W-phases. The AC output part ACOUT includes an AC output terminal U, an AC output terminal V, and an AC output terminal W connected to the power lines of the U, V, and W-phases, respectively.

The charging circuit 140 is provided in a section of the positive line PL between the rectifier circuit 110 and the smoothing capacitor 122. For example, as illustrated in FIGs. 1 and 2, the charging circuit 140 may be provided in a section of the positive line PL between the rectifier circuit 110 and the smoothing capacitor 122. Alternatively, for example, the charging circuit 140 may be provided in a section of the positive line PL between the reactor 124 and the smoothing capacitor 122. The charging circuit 140 includes a switch 142 and a charging resistor 144.

The switch 142 is provided in a section of the positive line PL between the rectifier circuit 110 and the smoothing circuit 120 (or the reactor 124). The switch 142 is configured to be capable of opening and closing the positive line PL. The switch 142 is, for example, a switching element such as a thyristor, triac, relay, or the like.

The charging resistor 144 is connected in parallel with the switch 142.

The charging circuit 140 functions such that a current flowing through the positive line PL toward the smoothing circuit 120 passes through the switch 142 when the switch 142 is turned on, or passes through the charging resistor 144 when the switch 142 is turned off. This enables the inverter device 1 to have a current flow through the charging resistor 144 when the switch 142 is turned off upon starting up of the inverter device 1, and thereby, to prevent a relatively large inrush current from flowing when charging the smoothing capacitor 122. Further, in the inverter device 1, once the smoothing capacitor 122 is charged up to a certain level, and the voltage between the positive line PL and the negative line NL becomes relatively high, the switch 142 is turned on and a current can flow through the positive line PL via the switch 142 having a relatively low electrical resistance. Specifically, when a voltage greater than or equal to a predetermined value is detected by a voltage detection circuit (not illustrated) that detects the voltage between the positive line PL and the negative line NL, it is determined that an inrush current is suppressed, and the switch 142 is turned on from the off state.

The DC input part DCIN is used for inputting DC power from the outside. The DC input part DCIN includes a positive DC terminal P and a negative DC terminal N.

The positive DC terminal P is pulled out of the positive line PL. For example, as illustrated in FIGs. 1 and 2, the positive DC terminal P may be pulled out of a section of the positive line PL between the charging circuit 140 and the inverter circuit 130, specifically, between the reactor 124 and the inverter circuit 130. Also, for example, as described above, in the case where the positional relationship between the reactor 124 and the charging circuit 140 along the positive line PL is reversed to that in FIGs. 1 and 2, the positive DC terminal P may be pulled out of a section of the positive line PL between the reactor 124 and the charging circuit 140.

The negative DC terminal N is pulled out of the negative line NL at any position. For example, as illustrated in FIG. 1, the negative DC terminal N is connected to a section of the negative line NL between the smoothing circuit 120 (the smoothing capacitor 122) and the inverter circuit 130, in the housing 1H.

Note that the DC input part DCIN may be omitted.

The control circuit unit 200 controls the inverter device 1.

Functions of the control circuit unit 200 may be implemented by any hardware devices or a combination of any hardware devices and software components. For example, the control circuit unit 200 is constituted with a computer that includes a central processing unit (CPU), a memory device such as a random access memory (RAM), a non-volatile auxiliary storage device such as a read-only memory (ROM), and an interface device for inputting and outputting with an external device.

The control circuit unit 200 includes a drive circuit 210, a control unit 220, a cut-off circuit 230, a power terminal PLC, input terminals EN1 and EN2, a common terminal CM, an input circuit 240, and a change-over switch 250.

The drive circuit 210 outputs a drive signal for turning each semiconductor switching element on and off, to the inverter circuit 130 (the gate of the semiconductor switching element), under control of the control unit 220.

The control unit 220 generates, for example, a drive signal such as a PWM (Pulse Width Modulation) signal or the like to implement a predetermined operating state of the electric motor M, and outputs the drive signal through the drive circuit 210 to the inverter circuit 130 (each semiconductor switching element). This enables the control unit 220 to operate the inverter circuit 130 so as to drive and control the electric motor M.

The cut-off circuit 230 (an example of a signal-using part) is provided on a path (a signal line) between the control unit 220 and the drive circuit 210. The cut-off circuit 230 cuts off the signal path between the control unit 220 and the drive circuit 210, in response to predetermined digital signals (referred to as "safety signals", hereafter) input from the input terminals EN1 and EN2 and received by the input circuit 240. Specifically, the cut-off circuit 230 cuts off the signal path between the control unit 220 and the drive circuit 210 when a safety signal is input from at least one of the input circuits 241 and 242 that will be described later. This enables the cut-off circuit 230 to cut off transmission of a drive signal from the control unit 220 to the drive circuit 210, and as a result, can cut off power supplied from the main circuit unit 100 to the loading device (the electric motor M). Therefore, based on the safety signal input from the outside, the control circuit unit 200 can implement safe torque off (STO) as a safety function of cutting off the power supply to the loading device, by using the cut-off circuit 230.

The power terminal PLC is configured such that power from an internal power supply IPS can be output to the outside. The power terminal PLC is provided on the surface of the housing 1H, and connected inside the housing 1H to the positive electrode of the internal power supply IPS through a diode for preventing backflow.

The input terminals EN1 and EN2 are configured to be connectable to signal lines that transmit digital signals (safety signals) for activating the safety function.

For example, as illustrated in FIG. 1, in the operation mode of the safety function, the input terminals EN1 and EN2 are connected to an emergency stop switch ES. Also, as illustrated in FIG. 2, in the non-operation mode of the safety function, the input terminals EN1 and EN2 are not connected to signal lines, and stay in an unused state.

The emergency stop switch ES can be activated, for example, in response to an operation performed by a user (e.g., a worker or the like at a factory where a device electrically driven by the electric motor M is installed), and thus, the user can control output of a safety signal manually.

In the emergency stop switch ES, two normally closed switches connected in parallel are embedded. Each of the two switches has one end connected via a signal line to the input terminal EN1 or EN2, and has the other end connected via a signal line to the power terminal PLC.

In the case where the emergency stop switch ES is not operated, the two switches are in the closed state. Therefore, between the input terminals EN1-EN2 and the power terminal PLC, on the outside of the housing 1H, a short circuit is formed via the signal lines. Therefore, in a state where the emergency stop switch ES is not operated, the input terminals EN1 and EN2 receive as input digital signals having a relatively high electric potential (referred to as "H signals", hereafter) at all times.

On the other hand, in the case where the emergency stop switch ES is operated, the two switches transition from the closed state to the open state. Therefore, the connection between the input terminals EN1-EN2 and the power terminal PLC on the outside of the housing 1H, transitions to the cut-off state. Therefore, when the emergency stop switch ES is operated, the input terminals EN1 and EN2 receive as input digital signals having a relatively low electric potential (referred to as "L signals", hereafter) corresponding to safety signals.

The common terminal CM is a terminal of a reference electric potential common to the input terminals EN1 and EN2. The common terminal CM may be grounded inside the housing 1H. Also, the common terminal CM may be grounded, for example, through a signal line connected to the outside.

The input circuit 240 receives safety signals input from the input terminals EN1 and EN2, and outputs the signals to the cut-off circuit 230.

The input circuit 240 includes the input circuits 241 and 242.

The input circuit 241 is provided between the input terminal EN1 and the cut-off circuit 230, and configured to be capable of receiving a safety signal input from the input terminal EN1, and outputting the signal to the cut-off circuit 230.

The input circuit 241 includes a photocoupler 241A and an input resistor 241B.

The photocoupler 241A includes a photodiode 241A1 and a phototransistor 241A2.

The photodiode 241A1 has its anode connected to the input terminal EN1 via the input resistor 241B via a signal line, and has its cathode connected to the common terminal CM via a signal line.

The phototransistor 241A2 has its collector connected to a constant-voltage power supply CVS via a signal line, has its emitter grounded via an output resistor, and is connected with the cut-off circuit 230 via a signal line. The constant-voltage power supply CVS (an example of a constant electric potential part) is a power supply circuit having an output voltage of, for example, 5 V (volts).

The input circuit 242 is provided between the input terminal EN2 and the cut-off circuit 230, and configured to be capable of receiving a safety signal input from the input terminal EN2, and outputting the signal to the cut-off circuit 230.

The input circuit 242 includes a photocoupler 242A and an input resistor 242B.

The photocoupler 242A includes a photodiode 242A1 and a phototransistor 242A2.

The photodiode 242A1 has its anode connected to the input terminal EN2 via the input resistor 242B via a signal line, and has its cathode connected to the common terminal CM via a signal line.

The phototransistor 242A2 has its collector connected to the constant-voltage power supply CVS via a signal line, has its emitter grounded via an output resistor, and is connected with the cut-off circuit 230 via a signal line.

The change-over switch 250 (an example of a switching part) performs switching between the open/closed states of a path between the constant-voltage power supply CVS and a signal line on the output side of each of the input circuits 241 and 242, namely, a signal line connected to the emitter of each of the phototransistors 241A2 and 242A2. The change-over switch 250 mechanically switches the open/closed states, for example, in response to an operation performed by the user. The change-over switch 250 may be a slide switch that is provided at a location (e.g., on the substrate of the control circuit unit 200) readily visible to the user, for example, in a state where an openable/closable cover of the housing 1H is open, to allow the user to perform a slide operation between two positions.

The change-over switch 250 includes change-over switches 251 and 252.

The change-over switch 251 switches the open/closed states of a path between the constant-voltage power supply CVS and a signal line on the output side of the input circuit 241. When the change-over switch 251 is turned on and transitions to the closed state, the path between the constant-voltage power supply CVS and the signal line on the output side of the input circuit 241 transitions to the conductive state, and the signal line on the output side of the input circuit 241 is maintained at (fixed to) a relatively high electric potential, namely, an electric potential corresponding to the H signal.

The change-over switch 252 switches the open/closed states of a path between the constant-voltage power supply CVS and a signal line on the output side of the input circuit 242. When the change-over switch 252 is turned on and transitions to the closed state, the path between the constant-voltage power supply CVS and the signal line on the output side of the input circuit 242 transitions to the conductive state, and the signal line on the output side of the input circuit 242 is maintained at (fixed to) an electric potential corresponding to the H signal.

The change-over switches 251 and 252 are configured, for example, such that the user can perform on and off operations separately from each other. Alternatively, the change-over switches 251 and 252 may be configured, for example, such that the user can perform on and off operations collectively.

As illustrated in FIGs. 1 and 2, the change-over switches 251 and 252 stay in the off state in the operation mode of the safety function, and stay in the on state in the non-operation mode of the safety function.

### [Specific operations of input circuit]

Next, specific operations of the input circuit 240 will be described with reference to FIGs. 1 and 2.

### <In operation mode of safety function>

As illustrated in FIG. 1, in the operation mode of the safety function, as described above, the input terminals EN1 and EN2 are connected to the emergency stop switch ES by the signal lines, and the change-over switches 251 and 252 stay in the off state.

In a state where the emergency stop switch ES is not operated, as described above, H signals are input into the input terminals EN1 and EN2. Therefore, through the photodiodes 241A1 and 242A1 of the photocouplers 241A and 242A, currents flow from the input terminals EN1 and EN2 toward the common terminal CM, and the phototransistors 241A2 and 242A2 stay in the conductive state (the on state). Therefore, the paths between the constant-voltage power supply CVS and the cut-off circuit 230 stay in the conductive state, and the H signals are input into the cut-off circuit 230.

In this case, the cut-off circuit 230 maintains the signal path between the control unit 220 and the drive circuit 210 in the connected state, and thereby, the control unit 220 can output a drive signal to the inverter circuit 130 through the drive circuit 210.

On the other hand, when the emergency stop switch ES is operated, as described above, L signals as the safety signals are input into the input terminals EN1 and EN2. Therefore, through the photodiodes 241A1 and 242A1 of the photocouplers 241A and 242A, no current flows, and the phototransistors 241A2 and 242A2 stay in the nonconductive state (the off state). Therefore, the paths between the constant-voltage power supply CVS and the cut-off circuit 230 stay in the conductive state, and the L signals as the safety signals are input into the cut-off circuit 230.

In this case, the cut-off circuit 230 cuts off the signal path between the control unit 220 and the drive circuit 210. This enables the inverter device 1 to maintain a state in which output of a drive signal from the control unit 220 to the drive circuit 210 is disabled.

Also, as described above, when a safety signal (L signal) is input from at least one of the input circuits 241 and 242, the cut-off circuit 230 can cut off the signal path between the control unit 220 and the drive circuit 210. Therefore, for example, even if one of the normally closed switches embedded in the emergency stop switch ES fails, and becomes incapable of outputting a safety signal, in response to a safety signal from the other switch, the cut-off circuit 230 can cut off the signal path between the control unit 220 and the drive circuit 210. Also, similarly, even if one of the input circuits 241 and 242 fails, and becomes incapable of transmitting a safety signal to the cut-off circuit 230, by a safety signal transmitted by the other, the cut-off circuit 230 can cut off the signal path between the control unit 220 and the drive circuit 210.

In this way, in the operation mode of the safety function, the input circuit 240 transmits safety signals input from the input terminals EN1 and EN2 to the cut-off circuit 230, and in response to the transmitted safety signals, the cut-off circuit 230 cuts off the signal path between the control unit 220 and the drive circuit 210. In this way, the inverter device 1 can implement a safety function (STO) that stops supplying power to the electric motor M, in response to the safety signal input by an operation on the emergency stop switch ES.

### <In non-operation mode of safety function>

As illustrated in FIG. 2, in the non-operation mode of the safety function, as described above, the input terminals EN1 and EN2 stay in the unused state, and the change-over switches 251 and 252 stay in the on state.

Once the change-over switches 251 and 252 transition to the on state, as described above, the signal lines on the output side of the input circuits 241 and 242 transition to a state of being conductive with the constant-voltage power supply CVS, and are maintained at (fixed to) a relatively high electric potential. Therefore, a state in which the H signals are input into the cut-off circuit 230 from the input circuits 241 and 242 is maintained.

In this case, the cut-off circuit 230 maintains the signal path between the control unit 220 and the drive circuit 210 in the connected state, and thereby, the control unit 220 can output a drive signal to the inverter circuit 130 through the drive circuit 210.

In this way, the change-over switches 251 and 252 transitioned to the on state, can make the signals input from the input circuits 241 and 242 into the cut-off circuit 230 fixed to the H signals. Therefore, the inverter device 1 can implement a state in which the safety function is disabled (non-operation mode) by an operation of the change-over switch 250. In other words, the change-over switch 250 can perform switching between a state in which the safety function is enabled (operation mode), and a state in which the safety function is disabled (non-operation mode).

### [Other embodiments]

Next, the other embodiments will be described.

The embodiments described above can be modified and changed as appropriate.

For example, in the embodiment described above, although the input terminals EN1 and EN2 are connected with the emergency stop switch ES via signal lines, instead of the emergency stop switch ES, these terminals may be connected with another device that outputs a safety signal. For example, the input terminals EN1 and EN2 may be connected to a monitoring device or the like that monitors operational states of the electric motor M.

Also, for example, in the embodiment and modified/changed examples described above, although STO is provided as the safety function, other safety functions may be provided in place of or in addition to the STO. The other safety functions may include, for example, a safe stop function (SS) that stops the electric motor M while controlling the speed.

Also, for example, in the embodiment and modified/changed examples described above, the change-over switch 250 may open or close the paths between the constant-voltage power supply CVS and the signal lines on the output side of the input circuits 241 and 242, in response to an operation performed by the user, such that the process is partially processed by software. For example, the control circuit unit 200 may be configured to perform switching between the on/off states of the change-over switch 250 when a predetermined functional code is input through an input unit provided in the inverter device 1.

Also, for example, in the embodiment and modified/changed examples described above, instead of switching the open/closed states between the constant-voltage power supply CVS and the signal lines on the output side of the input circuits 241 and 242, the change-over switch 250 may perform switching between the open/closed states of paths between the constant-voltage power supply CVS and the signal lines on the input side of the input circuits 241 and 242. Specifically, the change-over switches 251 and 252 may be provided on the paths between the constant-voltage power supply CVS and the signal lines on the input side of the input circuits 241 and 242, namely, signal lines connected to the anodes of the photodiodes 241A1 and 242A1, respectively.

Also, for example, in the embodiment and modified/changed examples described above, although the change-over switch 250 switches the connection state between the constant-voltage power supply CVS and the signal lines on the input side or the output side of the input circuit 240, the change-over switch 250 may switch the connection state of signal paths between the input circuit 240 and the cut-off circuit 230. In other words, in the embodiment described above, although the change-over switch 250 performs switching between the enabled/disabled states of the input circuit 240 whether to receive the signals input through the input terminals EN1 and EN2, the change-over switch 250 may perform switching between the enabled/disabled states of the cut-off circuit 230 whether to use the signals received by the input circuit 240. Specifically, the change-over switch 251 may be configured to be a double-throw switch capable of performing switching between a state of connection being established between the signal line on the output side of the input circuit 241 and the input line of the cut-off circuit 230, and a state of connection being established between the signal line extending from the constant-voltage power supply CVS and the input line of the cut-off circuit 230. Further, in the operation mode, the change-over switch 251 may stay in the state of connection being established between the signal line on the output side of the input circuit 241 and the input line of the cut-off circuit 230 in the operation mode, and stay in the state of connection being established between the signal line extending from the constant-voltage power supply CVS and the input line of the cut-off circuit 230 in the non-operation mode. Similarly, the change-over switch 252 may be configured to be a double-throw switch capable of performing switching between a state of connection being established between the signal line on the output side of the input circuit 242 and the input line of the cut-off circuit 230 in the operation mode, and a state of connection being established between the signal line extending from the constant-voltage power supply CVS and the input line of the cut-off circuit 230. Further, in the operation mode, the change-over switch 252 may stay in the state of connection being established between the signal line on the output side of the input circuit 242 and the input line of the cut-off circuit 230 in the operation mode, and in the non-operation mode, stay in the state of connection being established between the signal line extending from the constant-voltage power supply CVS and the input line of the cut-off circuit 230. This enables in the operation mode, safety signals (L signals) input through the input terminals EN1 and EN2 to be transmitted from the input circuit 240 to the cut-off circuit 230, and thereby, the inverter device 1 can implement a state in which the safety function operates properly. On the other hand, in the non-operation mode, the signal input into the cutoff circuit 230 is fixed to the H signals, and thereby, the inverter device 1 can properly maintain a state in which the safety function does not operate.

Also, for example, in the embodiment described above, although the change-over switch 250 is provided for the input circuit 240 corresponding to the input terminals EN1 and EN2, a similar change-over switch may be provided for an input circuit corresponding to another input terminal. For example, such a similar change-over switch may be provided for an input circuit that corresponds to another input terminal that is connectable to a signal line to receive an input signal used for a function different from a safety function, or a signal for activating another function.

Also, for example, in the embodiment described above, although the change-over switch 250 fixes the signals output from the signal lines on the output side of the input circuits 241 and 242 to the H signal, in the case where signals input from the outside are H signals, it may be configured to fix the signals to L signals.

Also, for example, the elements in the embodiment described above (the input terminals EN1 and EN2, the input circuit 240, the change-over switch 250, etc.) may be provided in a drive device different from the inverter device 1 that drives a loading device, for example, in a servo amplifier (an example of a drive device).

### [Operations]

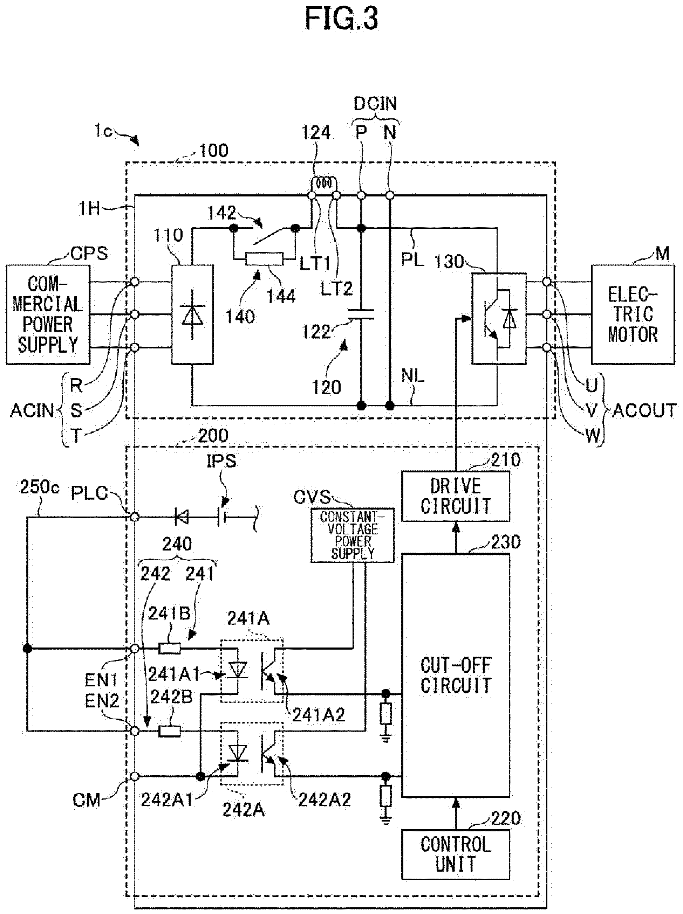

Next, with reference to FIG. 3, operations of the inverter device 1 (the control circuit unit 200) according to the present embodiment will be described.

FIG. 3 is a diagram illustrating a configuration of an inverter device 1c according to a comparative example. Specifically, FIG. 3 is a diagram illustrating a state of the inverter device 1c in the non-operation mode in which the safety function related to the electric motor M does not operate.

In FIG. 3, the same reference codes are attached to the components that are substantially the same as those in the inverter device 1 according to the embodiment described above.

As illustrated in FIG. 3, the inverter device 1c according to the comparative example is not provided with a change-over switch 250, and in this regard, different from the inverter device 1 in the embodiment described above. Therefore, in the non-operation mode of the safety function related to the electric motor M, paths between the power terminal PLC and the input terminals EN1 and EN2 are connected by a shorting bar 250c. Also, a jumper wire or the like may be used in place of the shorting bar 250c. In this way, a relatively high state of the electric potential of the input terminals EN1 and EN2 is maintained, and thereby, the inverter device 1c can maintain a state in which the H signals are input into the input terminals EN1 and EN2. Therefore, the inverter device 1c can maintain a state in which the H signals are input into the cut-off circuit 230 from the input circuit 240, and thereby, can implement the non-operation mode of the safety function.

However, in the case of the inverter device 1c in the comparative example, for example, assuming the non-operation mode of the safety function, when shipped from the factory, the shorting bar 250c or a jumper wire may need to be wired between the power terminal PLC and the input terminals EN1 and EN2. Therefore, the cost may increase by the additional work of wiring operations of the shorting bar 250c, the jumper line, or the like.

Also, in the case of the inverter device 1c according to the comparative example, there may be a risk of miswiring due to human errors in wiring operations of the shorting bar 250c, the jumper line, or the like. As a result, there is a likelihood that the inverter device 1c cannot properly implement the non-operation mode of the safety function.

Also, in the case of the inverter device 1c according to the comparative example, there is a likelihood that the shorting bar 250c, the jumper wire, or the like interferes with other wirings, and the workability in wiring operations becomes worse. As a result, there is a likelihood that the production efficiency of the inverter device 1c is reduced.

Also, in the case of the inverter device 1c in the comparative example, in the operation mode of the safety function, the shorting bar 250c may need to be removed by the user. Therefore, there is a likelihood that the user loses the shorting bar 250c.

In contrast, the inverter device 1 according to the present embodiment is provided with the input terminals EN1 and EN2, the input circuit 240, and the change-over switch 250. Specifically, the input terminals EN1 and EN2 are configured to be connectable with predetermined signal lines (e.g., signal lines extending from the emergency stop switch ES) that transmit predetermined signals (e.g., safety signals). Also, the input circuit 240 is connected to the input terminals EN1 and EN2, to receive signals input through the input terminals EN1 and EN2. Further, the change-over switch 250 performs switching between a first state in which the input circuit 240 is disabled to receive signals input through the input terminals EN1 and EN2, and a second state in which the input circuit 240 is enabled to receive signals input through the input terminals EN1 and EN2. Alternatively, the change-over switch 250 performs switching between a first state in which the inverter device 1 (the cut-off circuit 230) is disabled to use signals received by the input circuit 240, and a second state in which the inverter device 1 (the cut-off circuit 230) is enabled to use signals received by the input circuit 240.

In this way, it becomes unnecessary to use an external wire such as the shorting bar 250c or the jumper wire, to form a short circuit between the power terminal PLC and the input terminals EN1 and EN2. Therefore, the inverter device 1 can omit such an external wire that would be connected to the input terminals EN1 and EN that are assumed to stay in the unused state.

Also, in the present embodiment, the change-over switch 250 may perform switching between a first state in which the electrical electric potential of the input circuit 240 is maintained within a predetermined range (e.g., a range of electric potential corresponding to the H signal), and a second state in which the electric potential of the input circuit 240 can be varied according to signals input from the input terminals EN1 and EN2. In other words, the change-over switch 250 may perform switching between a first state of the input circuit 240 that is equivalent to a state in which the input terminals EN1 and EN2 are short-circuited with the power terminal PLC, and a second state of the input circuit that is equivalent to a state in which the input terminals EN1 and EN2 are not short-circuited with the power terminal PLC.

This enables, by using the change-over switch 250, the inverter device 1 to perform switching specifically between a first state in which the input circuit 240 is disabled to receive signals input through the input terminals EN1 and EN2, and a second state in which the input circuit 240 is enabled to receive signals input through the input terminals EN1 and EN2.

Also, in the present embodiment, the inverter device 1 is provided with a signal-using part (e.g., the cut-off circuit 230) that uses signals input through the input terminals EN1 and EN2. Further, the change-over switch 250 may perform switching between a first state in which a signal line is cut off between the output line of the input circuit 240 and the input line of the signal-using part, and a second state in which the signal line is cut off between the output line of the input circuit 240 and the input line of the signal-using part.

This enables, by using the change-over switch 250, the inverter device 1 to perform switching specifically between a first state in which use of signals received by the input circuit 240 is disabled, and a second state in which use of signals received by the input circuit 240 is enabled.

Also, in the present embodiment, the input terminals EN1 and EN2 may receive as input, via predetermined communication lines, signals used for a predetermined function of the inverter device 1.

This enables the inverter device 1 to switch the change-over switch 250 according to the necessity of signals for the predetermined function.

Also, in the present embodiment, the first state may correspond to a state in which the predetermined function (e.g., the safety function) is disabled, and the second state may correspond to a state in which the predetermined function is enabled.

This enables, by using the change-over switch 250, the inverter device 1 to perform switching between a first state in which the predetermined function is disabled (e.g., the non-operation mode), and a second state in which the predetermined function is enabled (e.g., the operation mode).

Also, in the present embodiment, the predetermined function may be a safety function (e.g., STO) of a loading device (e.g., the electric motor M) driven by the main circuit unit 100 of the inverter device 1.

This enables, by using the change-over switch 250, the inverter device 1 to perform switching between the first state in which the safety function related to the electric motor M is disabled (the non-operation mode), and the second state in which the safety function is enabled (the operation mode).

Also, in the present embodiment, the change-over switch 250 may mechanically perform switching between the first state and the second state in response to an operation performed by the user.

This enables the inverter device 1 to perform switching between the first state and the second state with a simpler configuration.

Also, in the present embodiment, in the first state, the electric potential of the input circuit 240 may be maintained at a range of electric potential corresponding to a high-level digital signal (H signal).

This enables the inverter device 1 to maintain a state in which the input circuit 240 does not receive as input L signals to be input from the input terminals EN1 and EN2, when the input terminals EN1 and EN2 are not used.

Also, in the present embodiment, the change-over switch 250 may perform switching between the open/closed states of a connection line connecting a predetermined location of the input circuit 240 and a constant electric potential part where the electric potential is maintained at a predetermined range (e.g., constant-voltage power supply CVS) .

This enables the inverter device 1 to perform switching specifically between a first state in which the electrical electric potential of the input circuit 240 is maintained within the predetermined range, and a second state in which the electric potential of the input circuit 240 can be varied according to signals input from the input terminals EN1 and EN2.

Also, in the present embodiment, the input circuit 241 may have the photocoupler 241A that includes the photodiode 241A1 connected to the input terminal EN1 via a signal line, and the phototransistor 241A2 connected to the output terminal via a signal line. Similarly, the input circuit 242 may have the photocoupler 242A that includes the photodiode 242A1 connected to the input terminal EN2 via a signal line, and the phototransistor 242A2 connected to the output terminal via a signal line. Further, the change-over switch 250 may be provided on connection lines that connect the constant electric potential (the constant-voltage power supply CVS), and the signal lines connecting the phototransistors 241A2 and 242A2 and the output terminal.

This enables the inverter device 1 to perform switching specifically between a first state in which the electrical electric potential of the input circuit 240 is maintained within a predetermined range, and a second state in which the electric potential of the input circuit 240 can be varied according to signals input from the input terminals EN1 and EN2.

## Claims

1. A drive device (1) comprising:
an inverter circuit (130) including at least one semiconductor switching element, wherein the inverter circuit (130) is configured to convert, by switching operations of the at least one semiconductor switching element, DC power into AC power, and to output the converted power to a loading device (M);
an input terminal (EN1, EN2) connectable to a predetermined signal line;
an input circuit (240, 241) connected to the input terminal (EN1, EN2) of the drive device (1) to receive a signal input through the input terminal (EN1, EN2);
a constant electric potential part (CVS) configured to provide an electric potential that is maintained within a predetermined range;
a control unit (220);
a drive circuit (210) configured to output to the inverter circuit (130) a drive signal for turning each semiconductor switching element on and off, under control from the control unit;
the control unit (220) configured to generate the drive signal, and to output the drive signal through the drive circuit (210) to the inverter circuit (130) for operating the inverter circuit (130) so as to drive the loading device (M);
a cut-off circuit (230) configured to receive an input signal and, based on the input signal, to cut off transmission of the drive signal from the control unit (220) to the drive circuit (210) by cutting off a signal path between the control unit (220) and the drive circuit (210); and
a switching part (250) configured to perform switching between a first state and a second state,
wherein in the first state the constant electric potential part (CVS) is enabled to provide the electric potential as the input signal to the cut-off circuit (230), and in the second state the input circuit (240, 241) is enabled to provide the signal input through the input terminal (EN1, EN2) as the input signal to the cut-off circuit (230).

2. The drive device (1) of claim 1, wherein the loading device (M) is an electric motor (M).

3. The drive device (1) of claim 1 or 2, wherein the predetermined range is a range of electric potential corresponding to a high-level digital signal.

4. The drive device (1) of any one of claims 1 to 3, wherein the input circuit (240, 241) includes a photocoupler (241A, 242A) that includes a photodiode (241A1, 242A1) connected to the input terminal (EN1, EN2), and a phototransistor (241A2, 242A2) connected to an output terminal of the input circuit (240, 241), wherein the output terminal is connected to the cut-off circuit (230).

5. The drive device (1) of any one of claims 1 to 4, wherein the input terminal (EN1, EN2) receives as input, via a predetermined communication line, a signal used for controlling a predetermined function of the drive device (1);
wherein the first state corresponds to a state in which the predetermined function is disabled, and the second state corresponds to a state in which the predetermined function is enabled,
wherein the predetermined function is a safety function of the loading device (M) driven by a main circuit unit (100) of the drive device (1).

6. The drive device (1) of any one of claims 1 to 5, wherein the switching part (250) is a change-over switch configured to perform mechanic switching between the first state and the second state in response to an operation of a user.

7. The drive device (1) of claim 6, wherein the switching part (250) is a slide switch configured to perform mechanic switching between the first state and the second state in response to a slide operation of the user.

## Patentansprüche

1. Ansteuervorrichtung (1), umfassend:
eine Wechselrichterschaltung (130), die mindestens ein Halbleiterschaltelement umfasst, wobei die Wechselrichterschaltung (130) konfiguriert ist, durch Schaltvorgänge des mindestens einen Halbleiterschaltelements Gleichstrom in Wechselstrom umzuwandeln und den umgewandelten Strom an eine Lastvorrichtung (M) auszugeben;
einen Eingangsanschluss (EN1, EN2), der mit einer vorbestimmten Signalleitung verbindbar ist;
eine Eingangsschaltung (240, 241), die mit dem Eingangsanschluss (EN1, EN2) der Ansteuervorrichtung (1) verbunden ist, um ein über den Eingangsanschluss (EN1, EN2) eingegebenes Signal zu empfangen;
einen Konstantes-elektrisches-Potenzial-Teil (CVS), der konfiguriert ist, ein elektrisches Potenzial bereitzustellen, das innerhalb eines vorbestimmten Bereichs aufrechterhalten wird;
eine Steuereinheit (220);
eine Ansteuerschaltung (210), die konfiguriert ist, ein Ansteuersignal zum Ein- und Ausschalten von jedem Halbleiterschaltelement unter der Steuerung von der Steuereinheit an die Wechselrichterschaltung (130) auszugeben;
wobei die Steuereinheit (220) konfiguriert ist, das Ansteuersignal zu erzeugen und das Ansteuersignal über die Ansteuerschaltung (210) an die Wechselrichterschaltung (130) auszugeben, um die Wechselrichterschaltung (130) derart zu betreiben, dass sie die Lastvorrichtung (M) ansteuert;
eine Abschaltschaltung (230), die konfiguriert ist, ein Eingangssignal zu empfangen und basierend auf dem Eingangssignal die Übertragung des Ansteuersignals von der Steuereinheit (220) an die Ansteuerschaltung (210) durch Abschalten eines Signalwegs zwischen der Steuereinheit (220) und der Ansteuerschaltung (210) abzuschalten; und
einen Schaltteil (250), der konfiguriert ist, ein Umschalten zwischen einem ersten Zustand und einem zweiten Zustand auszuführen,
wobei in dem ersten Zustand der Konstantes-elektrisches-Potenzial-Teil (CVS) aktiviert ist, das elektrische Potenzial als das Eingangssignal an die Abschaltschaltung (230) bereitzustellen, und in dem zweiten Zustand die Eingangsschaltung (240, 241) aktiviert ist, das über den Eingangsanschluss (EN1, EN2) eingegebene Signal als das Eingangssignal an die Abschaltschaltung (230) bereitzustellen.

2. Ansteuervorrichtung (1) nach Anspruch 1, wobei die Lastvorrichtung (M) ein Elektromotor (M) ist.

3. Ansteuervorrichtung (1) nach Anspruch 1 oder 2, wobei der vorbestimmte Bereich ein Bereich von elektrischem Potenzial ist, der einem Hochpegeldigitalsignal entspricht.

4. Ansteuervorrichtung (1) nach einem der Ansprüche 1 bis 3, wobei die Eingangsschaltung (240, 241) einen Optokoppler (241A, 242A) umfasst, der eine mit dem Eingangsanschluss (EN1, EN2) verbundene Fotodiode (241A1, 242A1) und einen mit einem Ausgangsanschluss der Eingangsschaltung (240, 241) verbundenen Fototransistor (241A2, 242A2) umfasst, wobei der Ausgangsanschluss mit der Abschaltschaltung (230) verbunden ist.

5. Ansteuervorrichtung (1) nach einem der Ansprüche 1 bis 4, wobei der Eingangsanschluss (EN1, EN2) über eine vorbestimmte Kommunikationsleitung ein Signal als Eingabe empfängt, das zum Steuern einer vorbestimmten Funktion der Ansteuervorrichtung (1) verwendet wird;
wobei der erste Zustand einem Zustand entspricht, in dem die vorbestimmte Funktion deaktiviert ist, und der zweite Zustand einem Zustand entspricht, in dem die vorbestimmte Funktion aktiviert ist,
wobei die vorbestimmte Funktion eine Sicherheitsfunktion der Lastvorrichtung (M) ist, die von einer Hauptschaltungseinheit (100) der Ansteuervorrichtung (1) angesteuert wird.

6. Ansteuervorrichtung (1) nach einem der Ansprüche 1 bis 5, wobei der Schaltteil (250) ein Umschalter ist, der konfiguriert ist, als Reaktion auf einen Betätigungsvorgang eines Benutzers ein mechanisches Umschalten zwischen dem ersten Zustand und dem zweiten Zustand auszuführen.

7. Ansteuervorrichtung (1) nach Anspruch 6, wobei der Schaltteil (250) ein Schiebeschalter ist, der konfiguriert ist, als Reaktion auf einen Schiebebetätigungsvorgang des Benutzers ein mechanisches Umschalten zwischen dem ersten Zustand und dem zweiten Zustand auszuführen.

## Revendications

1. Dispositif d'entraînement (1) comprenant :
un circuit inverseur (130) comprenant au moins un élément de commutation à semi-conducteur, dans lequel le circuit inverseur (130) est configuré pour convertir, par des opérations de commutation du au moins un élément de commutation à semi-conducteur, un courant continu en courant alternatif, et pour délivrer le courant converti à un dispositif de chargement (M) ;
une borne d'entrée (EN1, EN2) qui peut être reliée à une ligne de signal prédéterminée ;
un circuit d'entrée (240, 241) relié à la borne d'entrée (EN1, EN2) du dispositif d'entraînement (1) afin de recevoir un signal reçu par le biais de la borne d'entrée (EN1, EN2) ;
une partie à potentiel électrique constant (CVS) configurée pour fournir un potentiel électrique qui est maintenu dans des limites prédéterminées ;
une unité de commande (220) ;
un circuit d'entraînement (210) configuré pour délivrer au circuit inverseur (130) un signal d'entraînement destiné à activer et désactiver chaque élément de commutation à semi-conducteur, sous le contrôle de l'unité de commande ;
l'unité de commande (220) étant configurée pour générer le signal d'entraînement, et pour délivrer le signal d'entraînement par le biais du circuit d'entraînement (210) au circuit inverseur (130) afin de déclencher le circuit inverseur (130) de façon à entraîner le dispositif de chargement (M) ;
un circuit de coupure (230) configuré pour recevoir un signal d'entrée et, sur la base du signal d'entrée, pour couper la transmission du signal d'entraînement entre l'unité de commande (220) et le circuit d'entraînement (210) en désactivant un trajet de signal entre l'unité de commande (220) et le circuit d'entraînement (210) ; et
une partie de commutation (250) configurée pour effectuer un passage entre un premier état et un second état,
dans lequel, dans le premier état, la partie à potentiel électrique constant (CVS) est activée afin de fournir le potentiel électrique en guise de signal d'entrée au circuit de coupure (230), et, dans le second état, le circuit d'entrée (240, 241) est activé afin de fournir le signal d'entrée par le biais de la borne d'entrée (EN1, EN2) en guise de signal d'entrée au circuit de coupure (230).

2. Dispositif d'entraînement (1) selon la revendication 1, dans lequel le dispositif de chargement (M) est un moteur électrique (M).

3. Dispositif d'entraînement (1) selon la revendication 1 ou 2, dans lequel les limites prédéterminées sont des limites de potentiel électrique qui correspondent à un signal numérique de niveau élevé.

4. Dispositif d'entraînement (1) selon l'une quelconque des revendications 1 à 3, dans lequel le circuit d'entrée (240, 241) comprend un photocoupleur (241A, 242A) qui comprend une photodiode (241A1, 242A1) reliée à la borne d'entrée (EN1, EN2), et un phototransistor (241A2, 242A2) relié à une borne de sortie du circuit d'entrée (240, 241), dans lequel la borne de sortie est reliée au circuit de coupure (230).

5. Dispositif d'entraînement (1) selon l'une quelconque des revendications 1 à 4, dans lequel la borne d'entrée (EN1, EN2) reçoit, en guise d'entrée, via une ligne de communication prédéterminée, un signal utilisé pour contrôler une fonction prédéterminée du dispositif d'entraînement (1) ;
dans lequel le premier état correspond à un état dans lequel la fonction prédéterminée est désactivée, et le second état correspond à un état dans lequel la fonction prédéterminée est activée,
dans lequel la fonction prédéterminée est une fonction de sécurité du dispositif de chargement (M) entraîné par une unité de circuit principale (100) du dispositif d'entraînement (1).

6. Dispositif d'entraînement (1) selon l'une quelconque des revendications 1 à 5, dans lequel la partie de commutation (250) est un commutateur d'inversion configuré pour effectuer un passage mécanique entre le premier état et le second état en réponse à une opération d'un utilisateur.

7. Dispositif d'entraînement (1) selon la revendication 6, dans lequel la partie de commutation (250) est un commutateur à glissière configuré pour effectuer un passage mécanique entre le premier état et le second état en réponse à une opération de glissement de l'utilisateur.
